# EUROPEAN PATENT APPLICATION

(11) **EP 1 009 029 A1**
(43) Date of publication of application: **14.06.2000**
(21) Application number: 99124582.0
(22) Date of filing: 09.12.1999
(51) Int. Cl.: H01L 23/64, H01F 17/00

(54) **Semiconductor device and method of producing the same**

(30) Priority: 10.12.1998 JP 35127098
(71) Applicant: SONY CORPORATION, Tokyo (JP)
(72) Inventor: Chaen, Katsuhiro, c/o Sony Kokubu Corporation, Kokubu-shi, Kagoshima-ken (JP)
(74) Representative: MÜLLER & HOFFMANN Patentanwälte

(57) **Abstract**

To prevent collapse and delamination without increasing an occupied area or to reduce the area while maintaining a necessary strength, an inductor is provided by being formed on a first insulating layer on a semiconductor substrate comprises a plurality of metal layers stacked on the first insulating layer. Among the plurality of metal layers, the second insulating layer extends over the end portion of the lower-most metal layer from the first insulating layer. The other metal layers comprising the inductor are formed in contact with the upper surface of the lower-most metal layer which is not covered with the second insulating layer. The lower-most metal layer is preferably formed on the first insulating layer via a bonding layer (not shown). The lower-most layer is pressed down at the circumference by the second insulating layer, so an external force is not imposed directly on the interface between the metal layer and the insulating layer.

## Description

### BACKGROUND OF THE INVENTION

### 1. Field of the Invention

The present invention relates to a semiconductor device having an inducer, more particularly relates to a GaAs MMIC (monolithic microwave integrated circuit) or other semiconductor device having an inductor comprised of metal and a method of producing the same.

### 2. Description of the Related Art

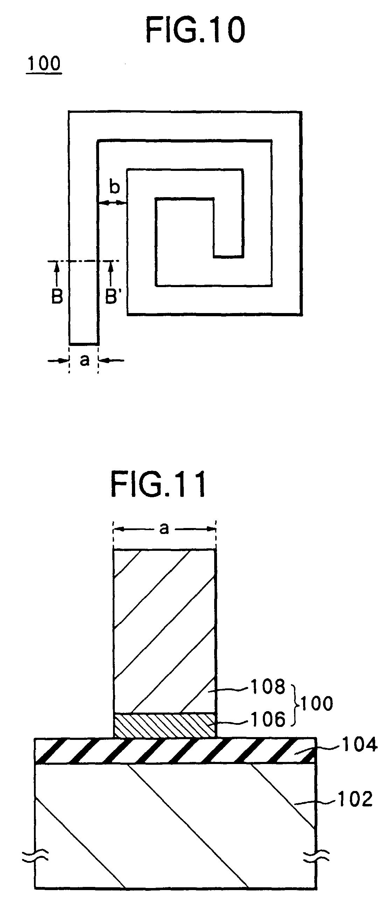

As shown in the cross-sectional view of Fig. 11, an inductance element (inductor) 100 mounted, for example, in a GaAs MMIC has been formed by patterning a stacked film of a bonding film 106 such as a Ti film for preventing delamination and an Au layer 108 in a spiral shape as shown in Fig. 10 on an insulating film 104 on a semiconductor substrate 102.

In the inductor 100, however, the strength against collapse and delamination depends on the bonding strength at the interface between the insulating film 104 and the metal film (bonding film) 106, so there has been the disadvantage of susceptability to an externally imposed force.

In such an inductor structure, to improve the above strength, it is effective to increase the contact area of the insulating film 104 and the bonding film 106.

In this method, however, as shown in Figs. 10 and 11, there is the disadvantage that when the width a of a line comprising the inductor 100 increases, the area occupied by the inductor 100 as a whole increases.

The area of an inductor is inherently larger than that of a transistor etc. Inductors are often used for grounding the input and output in an MMIC etc. Therefore, reduction of the area occupied by an inductor is strongly desired when reducing the size of MMICs.

The above measures for prevention of delamination of an inductor by increasing the contact area is not preferable since it runs counter to the desire of reducing the area occupied by the inductor.

### SUMMARY OF THE INVENTION

An object of the present invention is to provide a semiconductor device structured to be able to prevent collapse and delamination of an inductor without increasing an occupied area or to further reduce the area of the inductor while preventing the collapse and delamination, and a method of producing the same.

A semiconductor device of the present invention comprises a semiconductor device having an inductor on a first insulating layer on a semiconductor substrate, wherein said inductor is comprised of a plurality of metal layers stacked on said first insulating layer; a second insulating layer extends from said first insulating layer on an end portion of a lower-most metal layer among said plurality of metal layers; and other metal layers comprising said inductor are formed contacting an upper surface portion of the lower-most metal layer not covered with said second insulating layer.

The lower-most metal layer is preferably formed on said first insulating layer via a bonding layer.

In a semiconductor device having such a structure and method of producing the same, the lower-most layer functions as a so-called anchor portion of the inductor. Namely, since an end portion of the lower-most layer is pressed down by a second interlayer insulating film, the force applied from the outside is not directly imposed on the metal-insulating film interface beneath it. As a result, the externally imposed force rather acts to cause delamination at the interface between other metal layer above it and the lower-most layer. The interface is a metal-metal bond which is stronger than a metal-insulating film interface. Therefore, an inductor in a semiconductor device having the above configuration has greater strength against collapse and delamination than an inductor of the conventional structure where the external force acts directly on the metal-insulating film interface.

### BRIEF DESCRIPTION OF THE DRAWINGS

These and other objects and features of the present invention will become clearer from the following description of the preferred embodiments given with reference to the accompanying drawings, in which:
Fig. 1 is a plane view of an inductor according to an embodiment of the present invention;
Fig. 2 is a cross-sectional view along the line A-A' in Fig. 1 according to a first embodiment of the present invention;
Fig. 3 is a cross-sectional view of a manufacturing step of the inductor shown in Fig. 2;
Fig. 4 is a cross-sectional view of the inductor showing the manufacturing step following that in Fig. 3 up to formation of an opening in a second interlayer insulating film;
Fig. 5 is a cross-sectional view of the inductor showing the manufacturing step following that in Fig. 4 up to formation of a second metal layer.
Fig. 6 is a cross-sectional view of the inductor showing the manufacturing step following that in Fig. 5 up to formation of a third metal layer (electroplating);
Fig. 7 is a cross-sectional view along the line A-A' in Fig. 1 of the inductor according to a second embodiment;
Fig. 8 is a cross-sectional view of a manufacturing step of the inductor shown in Fig. 7 showing up to formation of a second metal layer;
Fig. 9 is a cross-sectional view of the inductor showing a manufacturing step showing up to formation of a resist serving as an etching mask for patterning of a second metal layer;
Fig. 10 is a plane view of an inductor of the related art; and
Fig. 11 is a cross-sectional view of the conventional inductor along the line B-B' in Fig. 10.

### DESCRIPTION OF THE PREFERRED EMBODIMENTS

Below, preferred embodiments will be described with reference to the accompanying drawings.

### First Embodiment

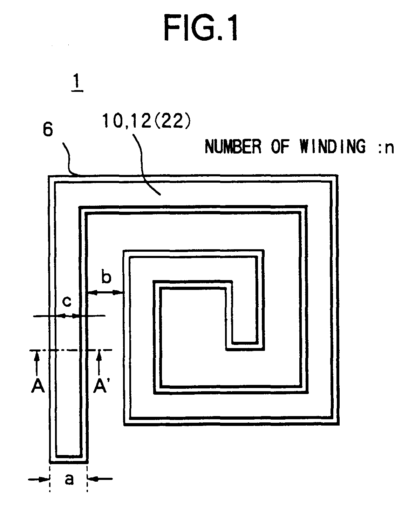

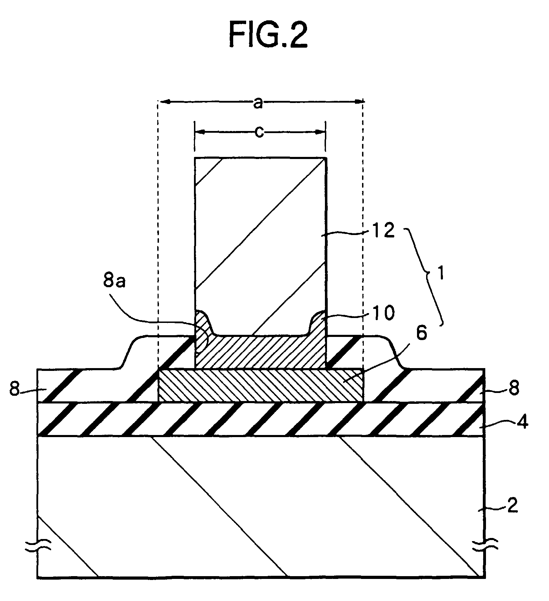

Figure 1 is a plane view of an inductor according to the present embodiment, while Fig. 2 is a cross-sectional view along the line A-A' in Fig. 1.

The spiral inductor 1 is, as shown in Fig. 1, a semi-spiral inductor wherein ends of high impedance lines respectively forming a rectilinear string band are successively connected in a spiral shape. In the portions of the lines comprising sides of the rectangle connected rectilinear string band, the line width a in accordance with a desired impedance and the separating distance b for giving sufficient connection therebetween are determined are determined. Further, the number of windings n for obtaining the desired inductance is also determined. Note that a plane shape of the spiral inductor 1 is not limited to Fig. 1 and it may be a in a polygon shape.

Also, in the cross-sectional configuration along the line A-A' in Fig. 1 shown in Fig. 2, the material and the thickness of the transmission line are determined to given a desired impedance in consideration of the various process limitations.

In Fig. 2, a first interlayer insulating film 4, for example, comprised of silicon nitride is formed on a GaAs or other semiconductor substrate 2. The lower-most metal layer 6 comprising the inductor 1 is formed thereon by the spiral pattern in Fig. 1. The lower-most metal layer 6 is comprised of Au having a thickness of for example 200 nm. While not shown in the figure, the lower-most metal layer 6 is formed on a first interlayer insulating film 4 via a Ti film of for example about 50 nm as a bonding layer.

A second interlayer insulating film 8 comprised of for example silicon nitride is stacked on the first interlayer insulating film 4. The second interlayer insulating film 8 extends over the end portion of the lower-most metal layer 6 (a portion on both sides of the width c in Fig. 1). Namely, the second interlayer insulating film 8 presses the lower-most metal layer 6 from above in order that the lower-most metal layer 6 is made difficult to be delaminated from the first interlayer insulating film 4. In the example shown in Figs. 1 and 2, the second interlayer insulating film 8 extends over the circumference of the lower-most metal layer 6. In other words, the second interlayer insulating film 8 of the present example has an opening portion 8a indicated by a width c in Fig. 1 on the lower-most metal layer 6.

The second and other metal layers comprising the inductor 1 are stacked in contact with the surface of the lower-most metal layer 6 exposed due to the opening portion 8a of the second interlayer insulating film 8. In the example in Fig. 2, an Au film 10 is formed by for example vapor deposition or sputtering to a thickness of for example about 250 nm as a second metal layer so as to bury the opening portion 8a of the second interlayer insulating film 8. An Au film 12 is formed relatively thickly, for example, to about 4.0 to 4.5 µm, by almost the same pattern on the Au film 10.

In the present example, the third Au film 12 is made thick for narrowing the width a of the transmission line to give a predetermined impedance and thereby reduce the area occupied by the inductor 1. While the details will be explained later on, the third Au film 12 is formed by an electroplating method. At that time, the second Au film 10 is used as an electrode.

The method of manufacturing an inductor having this configuration will be explained below.

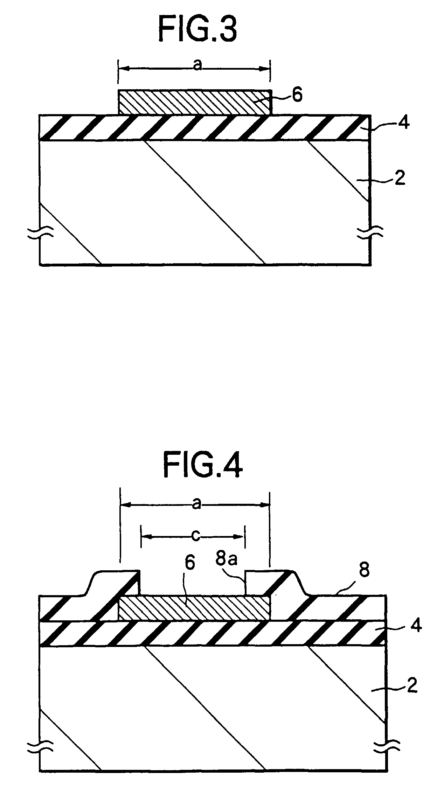

Figures 3 to 6 are cross-sectional views of steps in manufacturing the inductor along the line A-A' in Fig. 1. Namely, Figs. 3 to 6 are partial cross-sectional views forming the inductance 1 having a plane pattern shown in Fig. 1.

In Fig. 3, for example, a silicon nitride film 4 serving as a first interlayer insulating film is formed to a thickness of about 200 nm by the plasma CVD method on a GaAs wafer or other semiconductor substrate 2.

On the silicon nitride film 4, a Ti film serving as a bonding layer is formed by for example vapor deposition or sputtering to a thickness of about 50 nm and an Au film 6 serving as a first metal layer is formed by for example vapor deposition or sputtering to a thickness of about 200 nm.

For example, a resist pattern is formed on the Au film 6 and used as a mask to remove unnecessary portions of the Au film 6 and the Ti film by for example ion-milling to obtain a pattern of the sectional view shown in Fig. 3.

In Fig. 4, a silicon nitride film 8 serving as a second interlayer insulating film is formed over the entire surface to a thickness of about 250 nm by a plasma CVD method.

A resist pattern is formed on the silicon nitride film 8 by removing the upper portion of the Au film 6 and used as a mask to form an opening 8a on the Au film 6 by etching the silicon nitride film 8 by for example RIE (reactive ion etching) until the Au film 6 appears.

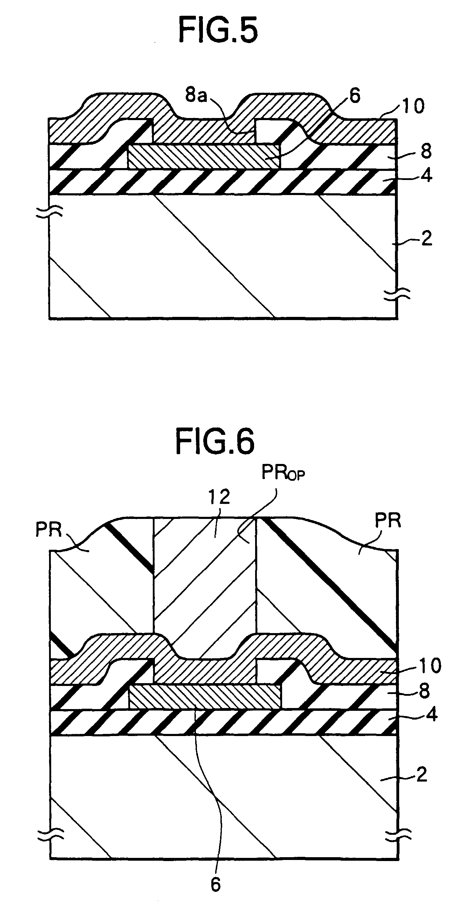

As shown in Fig. 5, an Au film 10 serving as a second metal layer is formed over the entire surface to a thickness of about the same as that of the nitride silicone film 8, for example 250 nm, by vapor deposition or sputtering so as to bury the opening 8a.

In Fig. 6, for example, a resist PR is coated to a thickness of about 4 µm and baited, then an opening portion PR_{OP} in the resist PR is formed above the opening portion 8a of the above second interlayer insulating film 8 by lithography.

Then, an Au plating layer 12 serving as a third metal layer is grown to a thickness of about the same as that of the resist PR, for example, about 4.0 to 4.5 µm at the opening portion PR_{OP} of the resist PR by an electroplating method using the above second Au layer 10 as an electrode.

Next, when removing the resist PR and ion-milling the entire surface, the Au layer 10 around the Au plating layer 12 is removed and the inductor 1 shown in Fig. 2 is completed.

In an inductor 1 of such a configuration, the Au layer 6 with its circumference pressed down by the second interlayer insulating film 8 functions as a so-called anchor portion.

In the case of a structure without an anchor portion, that is, when the lower-most metal layer 6 is not pressed down by the second interlayer insulating film 8, even if a Ti bonding layer is provided, delamination easily occurs at the metal-insulating layer interface. Therefore, collapse and delamination of the inductor easily occur.

In the inductor 1 of the present embodiment, however, since the circumference of the Au film 6 is pressed down by the second interlayer insulating film 8, almost no stress is applied to the metal-insulating layer interface. Even if the inductor collapses in this structure, it is highly probable that delamination will occur between the first and second metal layers 6 and 8. However, since the interface is a metal-to-metal bond, the bond strength is much greater than that of a metal-insulating film interface. Therefore, there is the advantage that collapse, delamination, etc. of the inductor will occur much less easily compared with the case wherein the circumference of the Au film 6 is not pressed down by the second interlayer insulating film 8.

Furthermore, the inductor 1 of the present embodiment can ensure sufficient strength against collapse and delamination even if the height is made greater by narrowing the line width, therefore there is the advantage that the area occupied by the element can be reduced more.

### Second Embodiment

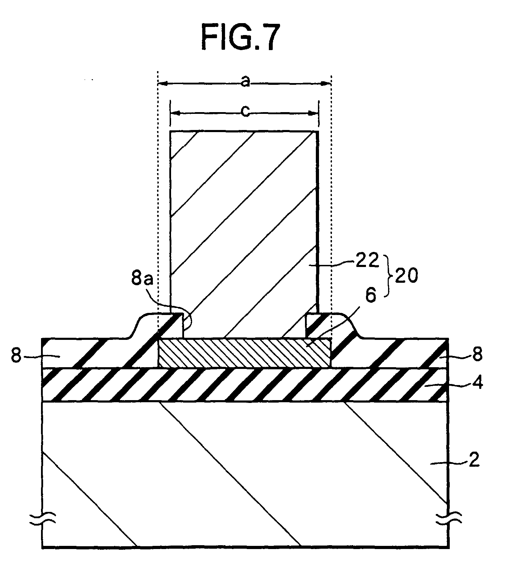

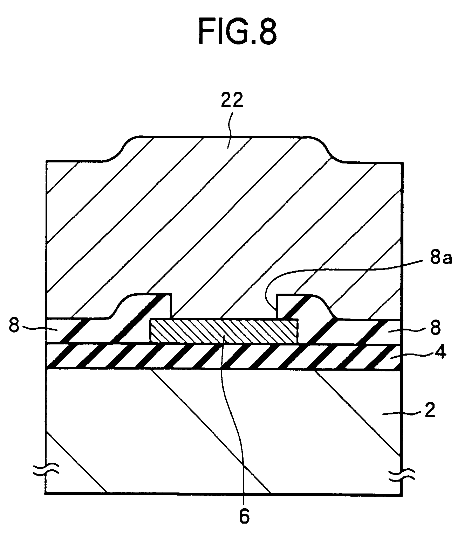

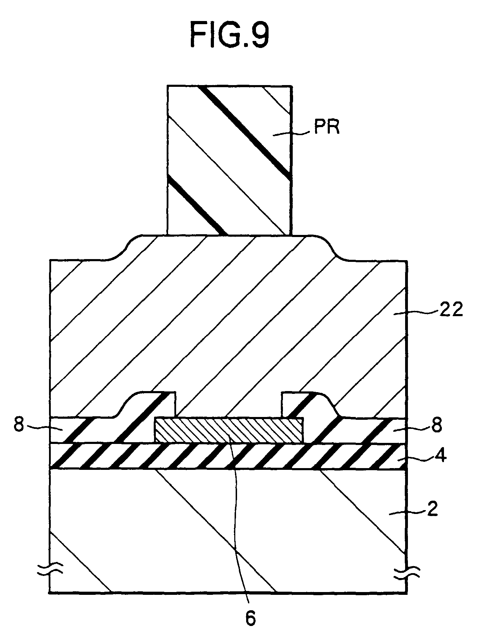

Figure 7 is a cross-sectional view of the structure of an inductor according to the present embodiment. Figures 8 and 9 are cross-sectional views showing the steps of production.

The inductor 20 differs from the first embodiment in the point that it is comprised of two metal layers 6 and 22. The upper metal layer 22 is formed by a little larger pattern than the opening portion 8a of the second interlayer insulating film 8 by ion-milling and is a layer composed of for example Au.

The rest of the configuration, that is, the semiconductor substrate 2, first interlayer insulating layer 4, lower-most metal layer 6, and second interlayer insulating film 8, are the same as those in the first embodiment.

When manufacturing the inductor 20, after completing the steps of Figs. 3 and 4 in the same way as in the first embodiment, a relatively thick second Au layer 22 is formed over the entire surface as shown in Fig. 8.

Next, a resist pattern PR as shown in Fig. 9 is formed on the Au film 22 and used as a mask for patterning the second Au layer 22 by ion-milling. As a result, the Au film 22 portion around the resist pattern PR is removed to obtain an inductor 20 having the structure shown in Fig. 7. Since the second embodiment has the configuration that the second interlayer insulating film 8 pressing down the circumference of the Au film 6 is pressed down by the Au layer 22, it has a higher resistance to delamination.

Although an inductor 20 of this structure and this manufacturing method requires patterning of the thick Au film 22 by ion-milling, there are the advantages that the structure and the manufacturing method themselves are simple in addition to the same advantages as in the first embodiment.

The present invention is not limited to the above embodiments and can be modified in various ways.

For example, in the first embodiment, the Au layer 12 may be formed by electroless plating. In that case, the second Au film 10 can be omitted.

The configuration of the inductor is not limited to two or three layers and may be four or more metal layers stacked together.

The portion pressed by the second interlayer insulating film 8 is not limited to the entire circumference of the lower-most Au layer 6. For example, if the mutually parallel two long sides of the lower-most Au layer 6 extending in a spiral are pressed down by the second interlayer insulating film, this is sufficient for preventing collapse and delamination. Also, it is effective to press only one of the two long sides.

In the above embodiments, GaAs was used as a semiconductor substrate of a high frequency device carrying the inductor, however, of course silicon may be also used.

The metal layers comprising the inductor are not limited to Au and may be Al or other metals. The material for the bonding layer is not limited to Ti either. Further, the bonding layer itself can be omitted.

The Au is generally patterned by ion-milling, however, depending on the metal material, the lower-most metal layer 6 can be patterned, the surroundings of the second metal layer 10 after the plating in the first embodiment can be removed, and the second metal layer 22 in the second embodiment can be patterned using RIE or other etching methods.

Furthermore, the pattern of the inductor is not limited to the semi spiral shape of Fig. 1. It may also be a polygon spiral shape, a normal continuous spiral shape, a meander line shape wherein parallel transmission lines are simply folded several times, or a high impedance line shape of a straight pattern sufficiently thinner than interconnections between elements.

According to the semiconductor device according to the present invention and the manufacturing method of the same, it is possible to prevent the collapse and delamination of an inductor without increasing its occupied area or the inductor area can be further reduced while preventing collapse and delamination.

While the invention has been described with reference to specific embodiment chosen for purpose of illustration, it should be apparent that numerous modifications could be made thereto by those skilled in the art without departing from the basic concept and scope of the invention.

## Claims

1. A semiconductor device having an inductor, comprising:
a substrate;
a first metal layer formed on the substrate;
an insulating layer formed on the first metal layer;
an opening formed in the insulating layer; and
a second metal layer formed on the opening;
said insulating layer covering an end portion of said first metal layer.

2. A semiconductor device as set forth in claim 1, further comprising a second insulating layer between said substrate and said first metal layer.

3. A semiconductor device as set forth in claim 2, further comprising a bonding layer having a higher bonding strength to the second insulating layer than the first metal layer does between said second insulating layer and said first metal layer.

4. A semiconductor device as set forth in claim 3, wherein said bonding layer is Ti.

5. A semiconductor device as set forth in claim 1, wherein said inductor is formed in a spiral shape.

6. A semiconductor device having an inductance comprising:
a substrate;
a first metal layer on the substrate formed to be a pattern for configuring the above inductance;
a first insulation layer having an opening positioned on the upper portion of the first metal film, covering the circumference of said first metal layer, and continuously extending on said substrate from the circumference; and
a second metal layer connected with said first metal layer via the opening of said first insulation layer, positioned above said first metal layer and configuring said inductance together with said first metal layer.

7. A semiconductor device having an inductance as set forth in claim 6, wherein said second metal film comprising:
a third metal layer having a thickness of about the same as that of said first insulation layer; and
a fourth metal layer formed above the third metal layer having a thicker thickness than those of the first metal layer and the third metal layer.

8. A semiconductor device having an inductance as set forth in claim 7, wherein:
said third metal film fills the openings formed on said first insulation layer; and
said forth metal film is a size of said opening and extends there above.

9. A semiconductor device having an inductance as set forth in claim 7, wherein:
said first and third metal films are formed by vapor deposition or sputtering; and
said fourth metal film is formed by plating method.

10. A semiconductor device having an inductance as set forth in claim 6;
wherein said second metal film comprises a fourth metal film formed on said first metal film and has a thicker thickness than that of the first metal film.

11. A semiconductor device having an inductance as set forth in claim 10, wherein:
said fourth metal film is formed to fill the opening of said first insulation layer to connect to said first metal film and extend over the portion covering the circumference of said first metal film of said first insulation layer.

12. A semiconductor device having an inductance as set forth in claim 11, wherein
said first metal film is formed by vapor deposition or sputtering; and
said fourth metal film is formed by plating method.

13. A semiconductor device as set forth in claim 6, wherein said bonding layer is Ti.

14. A semiconductor device as set forth in claim 6, wherein:
said substrate is a GaAs substrate; and
said plurality of metal layers comprising the inductor is Au.

15. A semiconductor device having an inductor as set forth in claim 6, wherein
said substrate is a semiconductor substrate;
a second insulation layer is formed between said substrate and said first metal film; and
said first insulation layer has an opening positioned above said first metal film, covers a circumference of said first metal film and continuously extends over said second insulation layer from the circumference.

16. A semiconductor device having an inductance as set forth in claim 15, wherein said substrate is a GaAs substrate.

17. A semiconductor device having an inductance as set forth in claim 16, wherein said first and second insulating layers are formed by silicon nitride.

18. A semiconductor device having an inductor as set forth in claim 6, wherein said substrate is a semi-insulating semiconductor substrate.

19. A semiconductor device having an inductance as set forth in claim 18, wherein a first insulation layer is formed by silicon nitride.

20. A semiconductor device having an inductance as set forth in claim 6, wherein said first metal film and second metal film are formed in a spiral shape on the surface of the substrate to compose the inductance.
